# EUROPEAN PATENT SPECIFICATION

(11) **EP 4 480 016 B1**
(45) Date of publication and mention of the grant of the patent: **11.11.2026**
(21) Application number: 23705022.4
(22) Date of filing: 17.02.2023
(51) Int. Cl.: H01M 4/04, B82Y 40/00, C30B 11/12, C30B 25/00, C30B 29/06, C30B 29/60, H01M 4/139, H01M 4/36, H01M 4/62, H01M 10/0525, H01M 4/134, H01M 4/1395, H01M 4/02, H01M 4/38

(54) **CARBON-COATED NANOWIRE NETWORK ELECTRODES**
KOHLENSTOFFBESCHICHTETE NANODRAHT-NETZWERKELEKTRODEN
ÉLECTRODES RÉSEAU EN NANOFILS REVÊTUS DE CARBONE

(30) Priority: 18.02.2022 EP 22382136
(43) Date of publication of application: 25.12.2024
(73) Proprietor: Fundación IMDEA Materiales, 28906 Getafe (Madrid) (ES)
(72) Inventor: PENDASHTEH, Afshin, 28223 Pozuelo de Alarcón (ES); RANA, Moumita, West Bengal 712410 (IN); SCHÄUFELE, Richard Santiago, 28012 Madrid (ES); VILATELA GARCÍA, Juan José, 28906 Getafe, Madrid (ES)
(74) Representative: ABG Intellectual Property Law, S.L.
(86) International application number: PCT/EP2023/054025
(87) International publication number: WO 2023/156590

(56) References cited:
- WO-A1-2021/094485
- BYOUNG MAN BANG ET AL: "Scalable approach to multi-dimensional bulk Si anodes via metal-assisted chemical etching", ENERGY & ENVIRONMENTAL SCIENCE, vol. 4, no. 12, 1 January 2011 (2011-01-01), pages 5013, XP055210180, ISSN: 1754-5692, DOI: 10.1039/c1ee02310a

## Description

### FIELD OF THE INVENTION

The present invention relates to the preparation of an electrode. More specifically, the present invention relates to a process for preparing an electrode for batteries and the electrode obtained by said method.

### BACKGROUND

Electrochemical energy generation and storage is a promising technology to power electric vehicles and devices of our modern society. The development of new types of electrodes is considered necessary to increase energy density of batteries relative to conventional lithium-ion batteries.

Networks of nanowires present advantages over materials made of larger building blocks. In general, nanowires are mechanically flexible due to their nanoscale dimensions and have a reduced amount of defects in comparison with bulk materials. They also display various properties resulting from their small size and one-dimensional morphology. Consequently, some of the properties of the nanowires networks depend on the characteristics of the nanowires.

Document WO2021094485 discloses an electrode comprising a network of nanowires and optionally an electrical connection or a current collector. According to said document, mechanical properties endowed by the nanowire network eliminate the use of reinforcing additives (e.g. polymeric binders) in the electrode and enable methods to process or integrate such electrode without the need for solvents or other forms of dispersion traditionally used. However, these types of electrodes have low values of electrical conductivity and thus, low capacity as electrodes in batteries, especially at fast charge/discharge rates, and poor retention of said capacity under repeated charge/discharge cycles (often termed as cyclability).

Also the study by Byoung Man Bang et al. "Scalable approach to multi-dimensional bulk Si anodes via metal-assisted chemical etching", Energy & Environmental Science, vol. 4, no. 12, 1 January 2011, page 5013, is directed to a method for coating silicon nanowires with a carbon layer containing graphitic carbon.

In spite of the different proposals made in the state of the art, there is a need to develop methods for synthesis of new electrodes and new electrodes with good mechanical and electrochemical properties (such as capacity and cyclability properties) that overcome prior art limitations.

### BRIEF DESCRIPTION OF THE INVENTION

The inventors of the present invention have found a method for producing an electrode comprising a network of nanowires coated with a carbon-based coating. The method of fabrication of the electrode produces a network of nanowires which is self-standing and has good mechanical properties, such as good flexibility in bending, and wherein the nanowires have high aspect ratios. In addition, said method is able to coat the nanowire network with a uniform carbon-based coating layer, capable of providing high electrical conductivity values that lead to high capacity and cyclability. Moreover, the method of the present invention is based on aerosol and gas-phase technology and has the potential of being scaled up to produce large amounts of product, while maintaining a high level of control over the process. In addition, the carbon-based coating layer of the electrode of the invention comprises crystalline graphitic domains that improve the electrochemical properties of said electrode, in particular its electrical conductivity. Moreover, the authors have observed that the interface between the nanowires of the network and the carbon coating comprises crystalline graphitic domains which are predominantly aligned. This feature is consequence of the carbon pyrolysis deposition step of the electrode synthesis method, and improves the final properties of the electrode.

Moreover, the electrode comprising a network of nanowires coated with a carbon-based coating of the invention, when tested in a cell, showed near-theoretical capacity values at low rates and even at high areal densities. In addition, said electrodes, show high specific capacity, high structural stability and high capacity retention and cyclability.

Thus, in a first aspect, the invention is directed to a method for preparing an electrode comprising:
(a) preparing a network of nanowires by a method comprising the steps of:
   i. providing a first gas flow to a reaction vessel;
      wherein said first gas flow comprises at least one precursor compound comprising at least one element selected from Si, Ge, Al, Cu, Zn, Sb, Ni, Ti, Se, Ta, Pt, Mo, V, W, Co, Mn and Li; wherein the at least one precursor compound is a metallic hydride or an organometallic compound; and
   ii. providing a second gas flow to the reaction vessel, said second gas flow comprising metallic catalyst particles; so as the first and second gas flows are mixed in the reaction vessel to form a gas flow mixture; wherein the metallic catalyst particles comprise one or more element selected from Au, Ag, Cu, **Fe,** Ni, Ga, Co, Pt, In and Al;

   wherein the at least one precursor compound is in the gas flow mixture in a mole fraction (xi) of at least 0.010;
   wherein the temperature inside the reaction vessel ranges from 200 to 3000 °C; and
   wherein the at least one precursor compound decomposes under the temperature inside the reaction vessel and grows on the metallic catalyst particles by vapor liquid-solid (VLS) and/or chemical vapor deposition (CVD) to form a network of nanowires; and
(b) coating the network of nanowires resulting from step (a) by pyrolysis of a carbon precursor at a temperature of between 500 and 1300°C under an inert gas atmosphere to obtain a network of nanowires coated with a carbon coating; and
(c) optionally, contacting the network of nanowires coated with a carbon coating with an electrical connection or current collector.

In a second aspect, the invention is directed to an electrode obtainable by the method of the invention in any of its particular embodiments, comprising
- a network of nanowires coated with a carbon coating;
   wherein the aspect ratio of the nanowires of the network of nanowires is at least 130;
   wherein the carbon coating comprises graphitic carbon; and
   wherein the carbon coating is in an amount of more than a 3 wt.% of the total weight of the network of nanowires coated with the carbon coating; and

- optionally, an electrical connection and/or a current collector.

In a further aspect, the invention is directed to a cell comprising:
- electrodes, wherein at least one electrode is as described in any of the embodiments of the present invention;
- an electrolyte; and
- means for connecting with a power/load source.

A further aspect of the invention is directed to the use of the electrode of the invention in any of its particular embodiments, in batteries; preferably in lithium batteries.

### FIGURES

Figure 1 shows an image of a self-standing Si nanowire network (a) before and (b) after carbon coating.
Figure 2 shows an electron micrograph of the Si nanowire network before carbon coating.
Figure 3 shows a HRTEM micrograph of the interface between the carbon coating and the crystalline Si of a Si nanowire network after carbon coating.
Figure 4 shows a representative Raman spectrum showing the crystallinity of the Si nanowires and the graphitization of the coating on the C coated Si nanowire network.
Figure 5 shows XRD patterns of a Si nanowire network after carbon coating.
Figure 6 shows (a) the first 10 cyclic voltammograms at a scan rate of 0.025 mV/s and (b) rate performance (specific capacity versus number of cycles) at C rates from C/20 to 2C obtained using the Si nanowire network coated with a carbon coating (with two different C contents: 27% and 5% weight percentage respectively) as electrode in a half-cell. Results of Si nanowire network coated with a 27wt% of carbon coating are showed as black circles and results of Si nanowire network coated with a 5wt% of carbon coating are shown as triangles. Electrode mass loading: 1.2 mg/cm² and 1C = 3.6 A/g.
Figure 7 shows (i) specific capacity vs number of cycles and (ii) coulombic efficiency of Si nanowire network coated with carbon as electrode at C-rates of (a) C/10 for 100 cycles and (b) C/2 for 500 cycles (1C = 3.6 A/g).
Figure 8 shows the rate performance (specific capacity versus number of cycles) at C rates from C/20 to 2C obtained using the Si nanowire network coated with a carbon (black circles) and results of Si nanowire network with interspersed carbon nanotubes (shown as squares). Electrode mass loading: 1.2 mg/cm² and 1C = 3.6 A/g.

### DETAILED DESCRIPTION OF THE INVENTION

The present invention refers to a method for preparing an electrode; to the electrode obtainable by said method; to a battery cell comprising the electrode, and to the use of the electrode.

Unless defined otherwise, all technical and scientific terms used herein have the same meaning as commonly understood to one of ordinary skill in the art to which this disclosure belongs. As used herein, the singular forms "a" "an" and "the" include plural reference unless the context clearly dictates otherwise.

In a first aspect, the invention is directed to a method for preparing an electrode comprising:
(a) preparing a network of nanowires by a method comprising the steps of:
   i. providing a first gas flow to a reaction vessel;
      wherein said first gas flow comprises at least one precursor compound comprising at least one element selected from Si, Ge, Al, Cu, Zn, Sb, Ni, Ti, Se, Ta, Pt, Mo, V, W, Co, Mn and Li; wherein the at least one precursor compound is a metallic hydride or an organometallic compound; and
   ii. providing a second gas flow to the reaction vessel, said second gas flow comprising metallic catalyst particles;
      so as the first and second gas flows are mixed in the reaction vessel to form a gas flow mixture;
      wherein the metallic catalyst particles comprise one or more element selected from Au, Ag, Cu, Fe, Ni, Ga, Co, Pt, In and Al;

   wherein the at least one precursor compound is in the gas flow mixture in a mole fraction (xi) of at least 0.010;
   wherein the temperature inside the reaction vessel ranges from 200 to 3000 °C; and
   wherein the at least one precursor compound decomposes under the temperature inside the reaction vessel and grows on the metallic catalyst particles by vapor liquid-solid (VLS) and/or chemical vapor deposition (CVD) to form a network of nanowires; and
(b) coating the network of nanowires resulting from step (a) by pyrolysis of a carbon precursor at a temperature of between 500 and 1300°C under an inert gas atmosphere to obtain a network of nanowires coated with a carbon coating; and
(c) optionally, contacting the network of nanowires coated with a carbon coating with an electrical connection or current collector.

### Step (a)

The method for preparing a network of nanowires may comprise a further step of transforming the network of nanowires into fibers, yarns or fabrics. The step of transforming the network of nanowires into fibers, yarns or fabrics is optionally performed at the same time than step (ii) of said method.

### Step (i)

The method for preparing a network of nanowires of step (a) comprises a step (i) of providing a first gas flow to a reaction vessel; wherein said first gas flow comprises at least one precursor compound comprising at least one element selected from Si, Ge, Al, Cu, Zn, Sb, Ni, Ti, Se, Ta, Pt, Mo, V, W, Co, Mn and Li; and wherein the at least one precursor compound is a metallic hydride or an organometallic compound.

In an embodiment the first gas flow further comprises a sheath-gas selected from nitrogen, hydrogen, noble gases and mixtures thereof; preferably H₂ or an inert gas, particularly N_{2.}

In an embodiment, the first gas flow consist of the at least one precursor compound and a sheath-gas selected from selected from nitrogen, hydrogen, noble gases and mixtures thereof; preferably H₂ or an inert gas, particularly N_{2.}

### Precursor

The step (i) of the method of the present invention provides a first gas flow to a reaction vessel wherein said first gas flow comprises at least one precursor compound.

In a particular embodiment, the at least one precursor compound is a compound that participates in a reaction (i.e. chemical reaction) that produces the nanowire network of the present invention, for example, SiH₄ is a precursor compound that when used in the method of the present invention may lead to a Si nanowire network.

In a particular embodiment, the at least one precursor compound of the method of the present invention comprises at least one element selected from Si, Ge, Al, Cu, Zn, Pt, Mo, V, W, Co, Mn and Li; particularly Si, Ge, Al, Cu, Zn, Pt, and Co; more particularly Si and Ge; even more particularly Si.

In an embodiment, the metallic element of the metallic hydride or of the organometallic compound of the at least one precursor compound is at least one element selected from Si, Ge, Al, Cu, Zn, Sb, Ni, Ti, Se, Ta, Pt, Mo, V, W, Co, Mn and Li; preferably selected from Si, Ge, Al, Cu, Zn, Pt, Mo, W, Co, Mn and Li; particularly Si, Ge, Al, Cu, Zn, Pt, and Co; more particularly Si, Ge and Al; even much more particularly Si and Ge; even more particularly Si. In a preferred embodiment, the metallic element of the metallic hydride or of the organometallic compound of the at least one precursor compound is one element selected from Si, Ge, Al, Cu, Zn, Sb, Ni, Ti, Se, Ta, Pt, Mo, V, W, Co, Mn and Li; preferably selected from Si, Ge, Al, Cu, Zn, Pt, Mo, W, Co, Mn and Li; particularly Si, Ge, Al, Cu, Zn, Pt, and Co; more particularly Si, Ge and Al; even much more particularly Si and Ge.

Precursors of the present invention include but are not limited compounds such as compounds comprising Si such as (3-Aminopropyl)triethoxysilane, N-sec-Butyl(trimethylsilyl)amine, chloropentamethyldisilane, tetramethylsilane, silicon tetrabromide, silicon tetrachloride, tris(tert-butoxy)silanol or SiH₄; compounds comprising Ge such as tetramethylgermanium, triethylgermanium hydride, triphenylgermanium hydride, triphenylgermanium hydride, tetramethylgermanium, tributylgermanium hydride, triethylgermanium hydride, triphenylgermanium hydride, compounds comprising Se such as dimethyl selenide; compounds comprising Al such as such as trimethylaluminium (TMAI) or triethylaluminium (TEAI), among others.

The at least one precursor compound may be in solid or liquid form (i.e. aerosolized in the first gas flow of the method of the present invention) or in gas form. In a particular embodiment, the at least one precursor compound is in gas form.

In a more particular embodiment, the at least one precursor compound is a metallic hydride, particularly SiH_{4.}

In a particular embodiment, the at least one precursor compound is one precursor compound.

In a particular embodiment, the first gas flow comprises more than one precursor compound. In particular, the first gas flow may comprise a first precursor compound and additional precursor compounds. In a particular embodiment, the additional precursor compounds may be used as dopants of the nanowire network (in less amount that the main precursor compound). Suitable dopants depend on the nanowire material being doped.

In a particular embodiment, the at least one precursor compound of the present invention is provided to the reaction vessel of the present invention at a rate of at least 0.01 mol/h; preferably at a rate of at least 0.05 mol/h; more preferably of at least 0.10 mol/h; even much more preferably of about 0.03 mol/h.

### Step (ii)

The method for preparing a network of nanowires of step (a) comprises a step (ii) of providing a second gas flow to the reaction vessel, said second glass flow comprising metallic catalyst particles; so as the first and second gas flows are mixed in the reaction vessel to form a gas flow mixture.

In an embodiment the second gas flow further comprises a sheath-gas selected from selected from nitrogen, hydrogen, noble gases and mixtures thereof; preferably H₂ or an inert gas, particularly N_{2.}

In an embodiment, the second gas flow consist of the metallic catalyst particles and a sheath-gas selected from selected from nitrogen, hydrogen, noble gases and mixtures thereof; preferably H₂ or an inert gas, particularly N_{2.}

In a particular embodiment, only one type of gas is used in the invention. In particular, the terms "first" and "second" are referred to the number of flows used.

In a particular embodiment, step (a) of the method for preparing a network of nanowires comprises a further step of collecting the network of nanowires; particularly by spinning and winding the network of nanowires (as a yarn or a fabric) on a bobbin.

### Catalyst

In a particular embodiment, the metallic catalyst particles of the method of the present invention comprise one or more element selected from Au, Ag, Cu, Fe, Ni, Ga, Co, Pt, In and Al; particularly comprise one or more element selected from Au, Ni, Ag and Cu; more particularly comprise one or more element selected from Au and Ag; even more particularly comprise Au. The metallic catalytic particles may consist of a single element, or a combination (e.g. alloy) of two or more elements. The metallic catalyst particles may be in the second gas flow as solid particles or as liquid particles; preferably as solid particles.

In another particular embodiment, the metallic catalyst particles of the method of the present invention further comprise one or more additional elements selected from group 16 elements to control and/or enhance the growth of nanowires. This additional elements are particularly selected from oxygen, sulfur, selenium, tellurium, and polonium; more particularly selected from S, Se, Te and O.

In a particular embodiment, the metallic catalyst particles consist of one element selected from Au, Ag, Cu, Fe, Ni, Ga, Co, Pt, In and Al; particularly consist of one element selected from Au, Ag and Cu; more particularly consist of one element selected from Au and Ag; even more particularly consist of Au.

In a particular embodiment, the metallic catalyst particles have an averaged diameter of between 0.1 and 100 nm; preferably of between 1 and 30 nm. The average diameters of the metallic catalyst particles of the present invention may be calculated from an average of the values obtained by measuring the diameters of more than 100 metallic catalyst particles using electronic microscopy micrographs or from the size distribution obtained from different aerosol measuring technics such as from a Differential Mobility Particle Sizer (DMA).

Furthermore, the metallic catalyst particles may be provided without electrical charge or the metallic catalytic particles may be given a charge.

The metallic catalyst particles may be provided to the reaction vessel in the form of an aerosol generated by an upstream aerosol generator. Alternatively, the metallic catalyst particles may be formed in-situ by providing a precursor compound; preferably a gaseous precursor compound. In a preferred embodiment, the metallic catalyst particles are provided in the form of an aerosol.

In a particular embodiment, the metallic catalyst particles enter the reaction vessel at a rate of at least 1 x 10⁻⁵ g/h; preferably of at least 1 x 10⁻⁴ g/h; more preferably of at least 2 x 10⁻⁴ g/h; even more preferably of at least 2.7 x 10⁻⁴ g/h.

### Gas flow mixture

In a particular embodiment, the gas flow mixture is generated when the first and the second gas flow are in contact in the reaction vessel. Means for mixture may be used to mix the flows to form a gas flow mixture. Pressure and flow rates might be adjusted if necessary to ensure a proper mixture of the first and second flow to form a gas flow mixture.

In a particular embodiment, the gas flow mixture circulates in the reaction vessel at a rate of at least 60 I/h; preferably at least 120 I/h.

In another particular embodiment, the gas flow mixture has a residence time in the reaction vessel of less than 100 seconds; particularly of between 0.1 and 80 seconds; more particularly of between 1 and 60 seconds; even more particularly of between 2 and 30 seconds; preferably of between 4 and 16 seconds.

In addition to the gas flow mixture, one or more sheath flows may be introduced in the reaction vessel of the present invention. Sheath flows include, but are not limited to, nitrogen, hydrogen and noble gases such as helium and argon.

In the method of the present invention the at least one precursor compound is in the gas flow mixture in a mole fraction (xi) of at least 0.010.

In a particular embodiment, the at least one precursor compound is in the gas flow mixture in a mole fraction of at least 0.012; preferably of at least 0.015; even more particularly of between 0.01 and 0.5; preferably of between 0.015 and 0.400; more preferably of between 0.016 and 0.100; more preferably of about 0.02. In the context of the present invention, the mole fraction is expressed as the amount of a constituent (in moles), divided by the total amount of all constituents (also expressed in moles).

In a particular embodiment, the at least one precursor compound of the present invention is in the gas flow mixture in a concentration of at least 0.1*10⁻⁴ mol/l; particularly in a concentration of at least 1*10⁻⁴ mol/l; more particularly in a concentration of at least 1.5*10⁻⁴ mol/l; even more particularly of at least 2*10⁻⁴ mol/l.

In a particular embodiment, the gas flow mixture comprises H_{2.}

In an embodiment, the gas flow mixture of the method of the invention comprises:
- at least one precursor compound;
- at least a sheath gas such as nitrogen, hydrogen and/or noble gases; and
- metallic catalyst particles.

In an embodiment, the gas flow mixture of the method of the invention consist of:
- at least one precursor compound;
- at least a sheath gas such as nitrogen, hydrogen and/or noble gases; and
- metallic catalyst particles.

In a preferred embodiment, the gas flow mixture of the method of the invention consist of:
- a precursor compound being a metallic hydride or an organometallic compound; wherein the metallic element of the metallic hydride or of the organometallic compound is at least one element selected from Si, Ge, Al, Cu, Zn, Sb, Ni, **Ti,** Se, **Ta,** Pt, Mo, V, W, Co, Mn and Li; preferably selected from Si, Ge, Al, Cu, Zn, Pt, Mo, V, W, Co, Mn and Li; particularly Si, Ge, Al, Cu, Zn, Pt, and Co; more particularly Si, Ge and Al; even much more particularly Si and Ge; even more particularly Si;
- a sheath gas or gas mixture selected from nitrogen, hydrogen, noble gases of combinations thereof; and
- metallic catalyst particles consisting of one element selected from Au, Ag, Cu, **Fe,** Ni, Ga, Co, Pt, In and Al; particularly consist of one element selected from Au, Ag and Cu; more particularly consist of one element selected from Au and Ag; even more particularly consist of Au.

### Reaction vessel

In a particular embodiment, the reaction vessel used in the method of step (a) is a gas reaction vessel; preferably a cylindrical reaction vessel; more preferably a ceramic or metallic cylindrical reaction vessel; even more preferably a stainless steel cylindrical reaction vessel such as a tube.

According to the method of the present invention, the first and second gas flows mix inside the reaction vessel.

In a particular embodiment, the temperature inside the reaction vessel is homogeneous; in particular is homogeneous within 50 degrees along the reactor tube, more particularly is homogeneous over 80 cm from the hot zone; particularly between 30-50 cm of the hot zone.

In the method of step (a) of the method of the present invention, the temperature inside the reaction vessel ranges from 200 to 3000°C; preferably the temperature ranges from 300 to 2800°C; more preferably the temperature ranges from 400 to 2000°C; even more preferably the temperature ranges from 500 to 1800°C.

In a particular embodiment, the pressure inside the reaction vessel is between 500 mbar to 20000 mbar (50000 Pa to 2000000 Pa); preferably between 900 mbar to 3000 mbar (90000 Pa to 300000 Pa).

In a particular embodiment, the temperature inside the reaction vessel is reached by any suitable means of heating known in the art; preferably by plasma, arc discharge, resistive heating, hot wire heating, torch heating, or flame heating means; more preferably by resistive heating, hot wire heating, torch heating, or flame heating means.

### Nanowire network growth

In step (a) of the method of the present invention, the at least one precursor compound decomposes under the temperature conditions inside the reaction vessel and grows on the metallic catalyst particles by vapor liquid-solid (VLS) and/or chemical vapor deposition (CVD) to form a network of nanowires. In a particular embodiment the nanowires grow while being in the gas flow mixture (i.e. they are aerosolized). In a particular embodiment, the at least one precursor compound decomposes under the temperature conditions inside the reaction vessel and grows on the metallic catalyst particles by floating catalyst chemical vapor deposition (CVD) to form a network of nanowires.

If necessary, one or more sheath flows may be introduced in the reaction vessel. In particular, said one or more sheath flows might be introduced between the gas flow mixture and the walls of the reaction vessel.

By choosing appropriate precursor compounds, gas flows, temperatures, pressures, and metallic catalyst particles, the nanowires can be grown in the axial or radial direction, or in a combination of the two growth modes; preferably growth occurs in axial direction; more preferably growth occurs in the 110 direction; particularly for Si nanowires.

Nanowire growth may be initiated by catalytic decomposition of the at least one precursor compound on the surface of the metallic catalyst particles and nucleation of the nanowire on the surface of the metallic catalytic particles. After nucleation, the nanowire may grow directionally and form an elongated object, i.e. a nanowire. Growth may occur via vapor liquid-solid (VLS) and/or chemical vapor deposition (CVD). At the same time, the nanowires reach a critical concentration and aggregate to form a network of nanowires in the reaction vessel. Thus, the method of the present invention is a continuous aggregated method. Preferably, the gas mixture flows through the reactor carrying metallic catalytic particles and the nanowire network flows through the reaction vessel length. In an embodiment, the network of nanowires comprises hollow nanowires such as nanotubes. In an embodiment the network of nanowires comprises hollow and not hollow nanowires such as solid nanowires. In another embodiment, the network of nanowires consist of hollow nanowires such as nanotubes.

In the context of the present invention, the expression chemical vapor deposition (CVD) is understood as a process in which one or more volatile precursor compounds react and/or decompose on a catalyst surface to produce one-dimensional structures, such as nanowires. Said catalyst particle may be suspended in the gas phase, commonly referred to as floating catalyst. Said particles may be in molten or solid state and may include additional elements to control and/or enhance growth of nanowires as described herein above. This additional elements include group 16 elements, such as S, Se, Te, or oxygen. Said precursors may also partially decompose on the surface of the reactor.

In a particular embodiment, the method for preparing a network of nanowires of the present invention is performed under an aerogelation parameter of at least 1 * 10⁻⁷; particularly under an aerogelation parameter of at least 1 * 10⁻⁶; more particularly under an aerogelation parameter of at least 2 * 10⁻⁶.

In the context of the present invention, the expression "aerogelation parameter" is understood as the product of the average aspect ratio of the nanowires (length/diameter) and the volumetric concentration (vc (volume of nanowires/volume of the reactor)).

In the context of the present invention, the expression "vapor-liquid-solid" (VLS) is a mechanism for the growth of one-dimensional structures, such as nanowires, from chemical vapor deposition by direct adsorption of a gas (i.e. the at least one precursor compound on gas phase) on to a liquid catalyst particle, which can rapidly adsorb a vapor to supersaturation levels, and from which crystal growth can occur from nucleated seeds at the gas-liquid-solid interface.

In a particular embodiment, a nanowire network is formed while being in the gas flow mixture (in the reaction vessel), particularly, a network of nanowires wherein the nanowires are aggregated (i.e. the nanowires are joined, entangled, connected or fused among them) is obtained at the exit of the reaction vessel of the present invention.

In a particular embodiment, the network of nanowires is generated as a continuous process. Alternatively, the network of nanowires may be discretely generated. In a preferred embodiment, the network of nanowires is continuously generated.

In a particular embodiment, the method of step (a) further comprises a step of collecting the network of nanowires on a substrate; preferably wherein the substrate is a filter; more preferably a vacuum filter. In a more particular embodiment, the method further comprises a step of densification of the network of nanowires; preferably by using a solvent or a mixture of solvents; more preferably an organic solvent or a mixture of organic solvents; even more preferably a solvent or a mixture of solvents comprising an alcohol group; even much more preferably using isopropanol.

In a particular embodiment, the network of nanowires is generated at a rate of at least 0.01 g/h; preferably at a rate of at least 0.02 g/h; more preferably at a rate of at least 0.05 g/h; even more preferably at a rate of about 0.1 g/h.

In another particular embodiment, the network of nanowires is generated at a rate of between 0.01 g/h and 10 g/h; preferably at a rate of between 0.02 g/h and 5 g/h; more preferably at a rate of between 0.05 g/h and 1 g/h; even more preferably at a rate of at between 0.09 g/h and 1 g/h.

### Step (b)

Step (b) of the method for preparing an electrode of the invention is directed to coating the network of nanowires resulting from step (a) with a carbon coating by pyrolysis of a carbon precursor at a temperature of between 500 and 1300°C under an inert gas atmosphere.

The coating of step (b) is formed when the carbon precursor decomposes at a temperature of between 500 and 1300°C under an inert gas atmosphere to lead to pyrolytic carbon that is deposited on the network of nanowires creating a carbon coating.

The carbon precursor of step (b) can be any compound known in the art that decomposes at a temperature of between 500 and 1300°C under an inert gas atmosphere to lead to pyrolytic carbon. Non-limiting examples of carbon precursors are organic molecules such as hydrocarbons, for example, acetylene.

In a particular embodiment, step (b) of the method for preparing an electrode of the invention is performed at a temperature of between 550 and 1200°C; preferably a between 600 and 1100°C; preferably between 620 and 1000°C; more preferably between 650 and 900°C; much more preferably between 660 and 850°C; even much more preferably at about 700°C.

Step (b) of the method for preparing an electrode of the invention is performed under an inert gas atmosphere, which means that it might be performed under a noble gases atmosphere or under N₂; for example using a gas flow comprising sheath-gas selected from any noble gases or N₂; preferably Ar or N₂; more preferably Ar.

In a more particular embodiment, the carbon precursor is a hydrocarbon or a mixture of hydrocarbons; preferably wherein the hydrocarbon or mixture of hydrocarbons comprise a hydrocarbon with a number of carbon atoms equal or lower than 10; more preferably equal or lower than 9, equal or lower than 8, equal or lower than 7, equal or lower than 6, equal or lower than 5, equal or lower than 4 or equal or lower than 3.

Non-limiting examples of hydrocarbons suitable as carbon precursors are methane, ethane, ethylene, acetylene, propane, propylene, methylacetylene, cyclopropane, propadiene, butane, butane, butyne, cyclobutane, butadiene, pentane, pentene, pentyne, cyclopentane, pentadiene, hexane, hexane, hexyne, cyclohexane, hexadiene or mixtures thereof; preferably methane, ethane, ethylene, acetylene, propane, propylene, methylacetylene, cyclopropane, propadiene, butane, butane, butyne, cyclobutane, butadiene, pentane, pentene, pentyne, cyclopentane, pentadiene and mixtures thereof; more preferably methane, ethane, ethylene, acetylene, propane, propylene, methylacetylene, cyclopropane, propadiene, butane, butane, butyne, cyclobutane, butadiene and mixtures thereof.

In a more particular embodiment, the carbon precursor is in gas or vapor phase; preferably is a gas.

In an embodiment, step (b) is performed in the same reaction vessel than step (a).

In a more particular embodiment, the carbon precursor is part of an additional gas flow introduced into the reaction vessel of step (a); preferably further comprising an inert gas.

In a particular embodiment, the carbon precursor is in at least a 1% in volume of the total volume of the gas flow; preferably at least a 2%; more preferably at least a 3%; even much more preferably about a 5%.

While not being bound by theory, the authors have observed that, as a consequence of the carbon pyrolysis deposition step of the electrode synthesis method, the carbon coating of the electrode of the invention comprises crystalline graphitic domains that improve the electrochemical properties of said electrode, in particular its electrical conductivity. Moreover, the interface between the nanowires of the network and the carbon coating comprises crystalline graphitic domains which are predominantly aligned, improving the final properties of the electrode.

In a particular embodiment, step (b) further comprises a step of drying the nanowires coated with a carbon coating; preferably at a temperature of between 80 and 150°C; more preferably at a temperature of between 90 and 140°C; even much more preferably at a temperature of about 120°C.

In an embodiment the drying step is performed under vacuum.

In another embodiment the drying step is performed for at least 4 hours; preferably for at least 6 hours.

In a particular embodiment, step (b) further comprises a step of pressing the nanowires coated with a carbon coating; preferably of mechanically pressing the nanowires coated with a carbon coating; more preferably applying a pressure of between 10⁵ and 10¹⁰ Pa, preferably between 10⁶ and 10⁹ Pa; more preferably at about 10⁸ Pa.

### Step (c)

The method of the present invention optionally comprises a further step (c) of contacting the network of nanowires coated with a carbon coating with an electrical connection or current collector.

In an embodiment, the electrical connection or current collector comprises an electrical conductive material such as a metallic material, for example, a metallic wire. The electrical connection of the previous embodiment may be done by any method known in the art.

### Electrode

As sated above, in a second aspect, the invention is directed to an electrode obtainable by the method according to the invention in any of its particular embodiments, comprising
- a network of nanowires coated with a carbon coating;
   wherein the aspect ratio of the nanowires of the network of nanowires is at least 130;
   wherein the carbon coating comprises graphitic carbon; and
   wherein the carbon coating is in an amount of more than a 3 wt.% of the total weight of the network of nanowires coated with the carbon coating; and
- optionally, an electrical connection and/or a current collector.

In a particular embodiment, the nanowires of the network of nanowires of the electrode of the present invention form a net; preferably the nanowires of the network of nanowires are joined, entangled, connected, fused or interlocked among them; preferably joined, entangled, connected or fused; more preferably joints are formed among them. In an embodiment, the net comprises aggregates of nanowires. In a particular embodiment the net is self-standing.

In a particular embodiment, the network of nanowires is self-standing. In the context of the present invention the term "self-standing" refers to a structure that is not supported by other objects or structures, such as a substrate. In an embodiment, the network of nanowires does not comprise an additional phase such as an additional matrix or binder. In an alternative embodiment, the network of nanowires consist of nanowires.

In a particular embodiment, the nanowires of the network of the electrode of the present invention are aggregated; particularly are strongly aggregated; particularly they are strongly aggregated by secondary forces such as van der Waals forces, permanent dipoles, hydrogen bonds and/or covalent bonds, entanglements and other forms of mechanical interlock. By strongly aggregated, in the context of the present invention it is implied that the materials form a solid object and that the nanowires that comprise the network cannot be easily dispersed without recourse to sonication, stirring, cutting or similar methods.

In a particular embodiment, the network of nanowires of the electrode of the present invention is a continuous network. In the context of the present invention, a continuous network is understood as a percolated non-discreet network.

In a particular embodiment, the network of nanowires of the present invention is an aerogel, i.e. a solid material of low density; preferably of a density of below 10⁻² g/cm³; preferably of below 10⁻³g/cm³; more preferably of below 10⁻⁴g/cm³; more preferably of below 10⁻⁵g/cm³. In a particular embodiment, the network of nanowires of the present invention has a density of at least 0.001 g/cm³; particularly of at least 0.01 g/cm^{3.}

In a more particular embodiment, the network of nanowires of the electrode of the present invention is densified; particularly by mechanical methods, solvents addition methods, electromagnetic methods or similar methods.

In a particular embodiment, the nanowires of the network of the present invention have an average aspect ratio (length/diameter) of at least 135; more preferably of at least 140; more preferably of at least 150; even more preferably of at least 200; even much more preferably at least 250.

In a more particular embodiment, the nanowires of the network of the present invention have an average aspect ratio (length/diameter) of between 135 and 1000; particularly of between 140 and 800; more particularly of between 150 and 700. The average aspect ratio of the nanowires of the network of the present invention may be calculated from an average of the values obtained by measuring the dimensions of a significant number of nanowires (for example, more than 100) using electron microscopy.

In a particular embodiment, the average length of the nanowires of the network of the present invention is at least 1 micron; particularly at least 2 microns; preferably at least 3, 4 or 5 microns; more preferably at least 10 microns. In a particular embodiment, the average length of the nanowires of the network of the present invention is between 1 and 30 microns; preferably between 2 and 20 microns; more preferably between 3 and 15 microns. The average length of the nanowires of the network of the present invention may be calculated from an average of the values obtained by measuring the lengths of more than 100 nanowires using electron microscopy.

In a particular embodiment, the nanowires of the network of nanowires of the electrode of the present invention comprises at least one material selected from AlₓGa₁₋ₓAs_{y}P_{1-y}, AIN, Al_{z}GaₓIn_{1-x-z}N, Si, SiC, Ge or SiₓGe₁₋ₓ, SiOₓ, TiOₓ, ZnOₓ, Taₓ, MoS_{y}, WS_{y}, MoTe_{y}, TaSe_{y}, NbSe_{y}, NiTe_{y}, BN, Cu, Pt, CoOₓ, MnOₓ, CuOₓ, VOₓ, LiₓMn_{y}O, LiₓNi_{y}Mn_{z}O and Niₓ wherein 0≤x≥1, 0≤y≥1 and 0≤z≥1; preferably comprise Si, SiC, Ge or SiₓGe₁₋ₓ and SiOₓ where 0≤x≥1; even more preferably comprises Si, Ge or SiₓGe₁₋ₓ and SiOₓ where 0≤x≥1; more preferably comprise Si or Ge; even more preferably comprises Si.

In another particular embodiment, the nanowires of the network of nanowires of the electrode of the present invention consist of at least one material selected from AlₓGa₁₋ₓAs_{y}P_{1-y}, AIN, Al_{z}GaₓIn_{1-x-z}N, Si, SiC, Ge or SiₓGe₁₋ₓ, SiOₓ, TiOₓ, ZnOₓ, Taₓ, MoS_{y}, WS_{y}, MoTe_{y}, TaSe_{y}, NbSe_{y}, NiTe_{y}, BN, Cu, Pt, CoOₓ, MnOₓ, CuOₓ, VOₓ, LiₓMn_{y}O, LiₓNi_{y}Mn_{z}O and Niₓ wherein 0≤x≥1, 0≤y≥1 and 0≤z≥1; preferably comprise Si, SiC, Ge or SiₓGe₁₋ₓ and SiOₓ where 0≤x≥1; even more preferably comprises Si, Ge or SiₓGe₁₋ₓ and SiOₓ where 0≤x≥1; more preferably comprise Si or Ge; even more preferably comprises Si.

In a particular embodiment, the nanowires of the network of nanowires of the electrode of the present invention comprises at least one material selected from AlₓGa₁₋ₓAs_{y}P_{1-y}, AIN, Al_{z}GaₓIn_{1-x-z}N, Si, SiC, Ge or SiₓGe₁₋ₓ, SiOₓ, TiOₓ, ZnOₓ, Taₓ, MoS_{y}, WS_{y}, MoTe_{y}, TaSe_{y}, NbSe_{y}, NiTe_{y}, BN, Cu, Pt, CoOₓ, MnOₓ, CuOₓ, VOₓ, LiₓMn_{y}O, LiₓNi_{y}Mn_{z}O and Niₓ wherein 0≤x≤2, 0≤y≤2 and 0≤z≤2; preferably comprise Si, SiC, Ge or SiₓGe₁₋ₓ and SiOₓ where 0≤x≤2; even more preferably comprises Si, Ge or SiₓGe₁₋ₓ and SiOₓ where 0≤x≤2; more preferably comprise Si or Ge; even more preferably comprises Si.

In a particular embodiment, the nanowires of the network of nanowires of the electrode of the present invention comprises at least one material selected from AlₓGa₁₋ₓAs_{y}P_{1-y}, AIN, Al_{z}GaₓIn_{1-x-z}N, Si, SiC, Ge or SiₓGe₁₋ₓ, SiOₓ, TiOₓ, ZnOₓ, Taₓ, MoS_{y}, WS_{y}, MoTe_{y}, TaSe_{y}, NbSe_{y}, NiTe_{y}, BN, Cu, Pt, CoOₓ, MnOₓ, CuOₓ, VOₓ, LiₓMn_{y}O, LiₓNi_{y}Mn_{z}O and Niₓ wherein 0≤x≤2, 0≤y≤2 and 0≤z≤2; preferably comprise Si, SiC, Ge or SiₓGe₁₋ₓ and SiOₓ where 0≤x≤2; even more preferably comprises Si, Ge or SiₓGe₁₋ₓ and SiOₓ where 0≤x≤2; more preferably comprise Si or Ge; even more preferably comprises Si.

In a particular embodiment, the network of nanowires of the electrode of the present invention has a volumetric density of at least 0.01 g/cm³; particularly of at least 0.05 g/cm³; more particularly of at least 0.075 g/cm³; even more particularly of at least 0.080 g/cm³ preferably of at least 0.015 g/cm³; more preferably of at least 0.020 g/cm³; even more preferably about 0.128 g/cm^{3.}.

In a particular embodiment, the network of nanowires of the electrode of the present invention has a volumetric density of between 0.01 g/cm³ and 0.2 g/cm³; particularly between 0.07 g/cm³ and 0.30 g/cm³. The volumetric density of the network of nanowires of the invention may be calculated from any experimental technique known in the art, particularly it determined from areal density and thickness of the sample of the network of nanowires.

In a particular embodiment, the nanowires of the network of nanowires are entangled; preferably are physically entangled.

In a particular embodiment, the network of nanowires is a network that comprises nanowires. In a particular embodiment, the nanowires forming the network can have the same or different properties. In a more particular embodiment, the nanowires comprised in the network have different composition and/or aspect ratios.

In a particular embodiment, the nanowires of the network of nanowires are hollow (i.e. they are nanotubes); preferably they are nanotubes. In a more particular embodiment, the hollow nanowires comprise Si, SiC, Ge or SiₓGe₁₋ₓ and SiOₓ wherein 0≤x≤2; more preferably consist of at least one material selected from Si and Ge; even more preferably consist of Si.

In a particular embodiment, the network of nanowires further comprise metallic catalyst particles; in particular, the metallic catalyst particles of the method of the present invention.

In a particular embodiment, the network of nanowires of the present invention further comprise particles; preferably quasi-spherical particles; more preferably quasi-spherical amorphous particles.

In a particular embodiment, the network of nanowires consists of nanowires and catalyst particles, and optionally particles; particularly quasi-spherical or spherical particles for example wherein the quasi-spherical particles are a result of the pyrolysis of the precursor compound of the method of step (a).

In a particular embodiment, the nanowires of the network of nanowires further comprise a labeling or marking element or compound; wherein said labeling element or compound allow their traceability. In a particular embodiment, the labeling or marking of the nanowires is performed during the synthesis process or after said synthesis, in an additional step.

In a particular embodiment, the nanowires of the network of nanowires are predominantly aligned.

In a particular embodiment, the nanowires of the network of nanowires are aligned by an electromagnetic, electrochemical, fluid-based or other methods.

In an embodiment, the network of nanowires of the electrode of the present invention comprises a crystalline phase and an amorphous phase; preferably, the crystalline phase is in at least a 50 wt% of the total weight of the network; more preferably in at least a 75 wt%; even more preferably in at least a 90 wt%; even more preferably the crystalline phase comprises crystalline nanowires and the amorphous phase comprises amorphous particles; preferably amorphous spherical particles.

In an embodiment, the network of nanowires of the present invention comprise at least a 50 wt% of crystalline nanowires of the total weight of the network; preferably at least a 75 wt%; more preferably at least 80wt%; even more preferably at least a 90 wt%.

In an embodiment, the nanowires of the network of nanowires are crystalline.

In an embodiment, the network of nanowires has fracture energy values of at least 0.05 J/g; preferably of between 0.1 and 0.5 J/g. Fracture energy values have been measured by mechanical tensile tests of network of nanowire samples using conventional mechanical testing equipment as known in the art.

In an embodiment, the network of nanowires has specific tensile strengths over 0.5 MPa/SG; preferably over 0.8 MPa/SG more preferably over 1 MPa/SG. In particular, specific tensile strengths values are in MPa/SG units, wherein SG stands for specific gravity being numerically equivalent to the density of the network of nanowires in units of g/cm³. Specific tensile strengths may be measured by any tensile test technique known in the art, for example may be measured by mechanical tensile measurements of samples of network of nanowires using a Textechno Favimat tensile tester at a strain rate of 10%/min and preferably at a gauge length of 5 mm.

### Carbon coating

In the context of the present invention, the expression "carbon coating" is directed to a carbon-based coating; in particular, said carbon coating has been obtained after step (b) of the method of the invention by pyrolysis of a carbon precursor at a temperature of between 500 and 1300°C under an inert gas atmosphere to obtain a network of nanowires coated with a carbon coating.

In an embodiment, the carbon coating is in an amount of more than a 3wt% of the total weight of the network of nanowires coated with the carbon coating; preferably more than a 5 wt%; preferably is in more than 6, 7 or 8 wt%; more preferably is in more than 10 wt%; more preferably is in more than 12 wt%; even much more preferably is in more than 15 wt%.

In an embodiment, the carbon coating is in an amount of more than a 3 wt.% and less than 50 wt% of the total weight of the network of nanowires coated with the carbon coating; preferably is in more than 5 and less than 49 wt%; preferably is in more than 5, 6, 7 or 8 wt.% and less than 45, 46 or 47 wt%; more preferably is in more than 10 wt.% and less than 40 wt%; more preferably is in more than 12 wt% and less than 38 wt%; even much more preferably is in more than 15 wt% and in less than 35 wt%.

In an embodiment, the carbon coating is in an amount of about 27 wt% of the total weight of the network of nanowires coated with the carbon coating.

The carbon coating comprises graphitic carbon.

In an embodiment, the carbon coating consist of graphitic carbon and non-graphitic carbon such as amorphous carbon.

In a particular embodiment, the graphitic carbon of the carbon coating comprises carbon graphitic planes aligned with the crystalline planes of the nanowires at the interface between the carbon coating and the nanowires.

In a more particular embodiment, when nanowires are Si nanowires, the graphitic (002) basal planes of the graphitic carbon of the carbon coating are oriented parallel to the Si (111) plane of the Si nanowires at the interface between the carbon coating and the nanowires.

In the context of the present invention the expression "graphitic carbon" is understood as all varieties of substances consisting of the element carbon in the allotropic form of graphite irrespective of the presence of structural defects or stacking disorder. The presence of graphitic carbon on a sample might be can be detected by diffraction methods known in the art.

In an embodiment, the electrode of the present invention has a porosity of between 60% and 90%; particularly of between 65% and 85%; more particularly of between 70% and 80%; even more particularly of about 78%. The porosity of the electrode has been measured using methods known in the art, such as determining the volume of a regular sample by optical and/or electron microscopy observation and measuring its weight gravimetrically.

In an embodiment, the electrode of the present invention has a volumetric density of between 0.05 and 0.70 g/cm³; preferably of between 0.10 and 0.65 g/cm³, more preferably of between 0.40 and 0.60 g/cm³; more preferably of about 0.51 g/cm³; wherein the volumetric density has been measured by determining the mass gravimetrically and dividing it by the volume of the electrode.

In an embodiment, the electrode of the present invention is electrically conductive. In a more particular embodiment, the electrode of the present invention has an electrical conductivity in the plane and out of plane in the range of 1-1.5 S/m and 0.1 to 0.6 S/m, respectively. Electrical conductivity of the electrode has been measured as known in the art by two-probe electrical resistance measurements using flat metal tape contacts

### Cell

In a further aspect, the invention is directed to a cell comprising:
- electrodes, wherein at least one electrode of the invention as described in any of the embodiments;
- an electrolyte; and
- means for connecting with a power/load source.

In an embodiment, the electrolyte of the cell of the invention comprises lithium. In a particular embodiment, the cell is a lithium battery; preferably is a lithium-ion battery.

In an embodiment, the at least one electrode is a working electrode. In another embodiment, the at least one electrode is an anode.

In another embodiment, the electrolyte of the cell is a gel electrolyte. In another embodiment, the electrolyte of the cell is solid.

### Uses

A further aspect of the invention is directed to the use of the electrode of the invention in any of its particular embodiments, in batteries; preferably in lithium batteries; more preferably in lithium-ion batteries.

An additional aspect of the invention is directed to a method for storage or delivery of electricity that comprises the step of using the electrode of the invention in any of its particular embodiments in a battery; preferably in a lithium battery; more preferably in lithium-ion batteries.

It should be understood that the scope of the present disclosure includes all the possible combinations of embodiments disclosed herein.

### EXAMPLES

The invention is illustrated by means of the following examples that in no case limit the scope of the invention.

### Example 1: Electrode

An electrode was fabricated by coating a network of nanowires comprising silicon (Si) nanowires, with a uniform carbon coating.

A network of nanowires comprising silicon (Si) nanowires was produced by the decomposition of a Si precursor in the presence of catalyst nanoparticles suspended in a gas stream inside a reaction vessel. In particular, the Si nanowires network was synthesized via Floating catalyst chemical vapor deposition (FCCVD) at 650°C using: a continuous flow of an aerosol of gold nanoparticles as catalyst, silane as precursor and a mixture of nitrogen and hydrogen as carrier gases. Molar fractions of gases were kept at 18:31:1 (N₂:H₂:SiH₄)). The reaction vessel used was a metallic reaction tube inside a tube furnace.

After the synthesis of the Si nanowire network, the network was coated with carbon by pyrolysis of acetylene gas (5% volume in Ar) at 700°C to form an electrode. The mass fraction of carbon in the electrode (nanowires network and carbon coating) was determined gravimetrically using a 5 digit high-precision weighing balance. Then, the Si nanowire network coated with carbon was dried overnight at 120°C under vacuum, and densified mechanically using a simple press at ambient temperature and applying a pressure of 10⁸ Pa. The results are a fully formed electrodes.

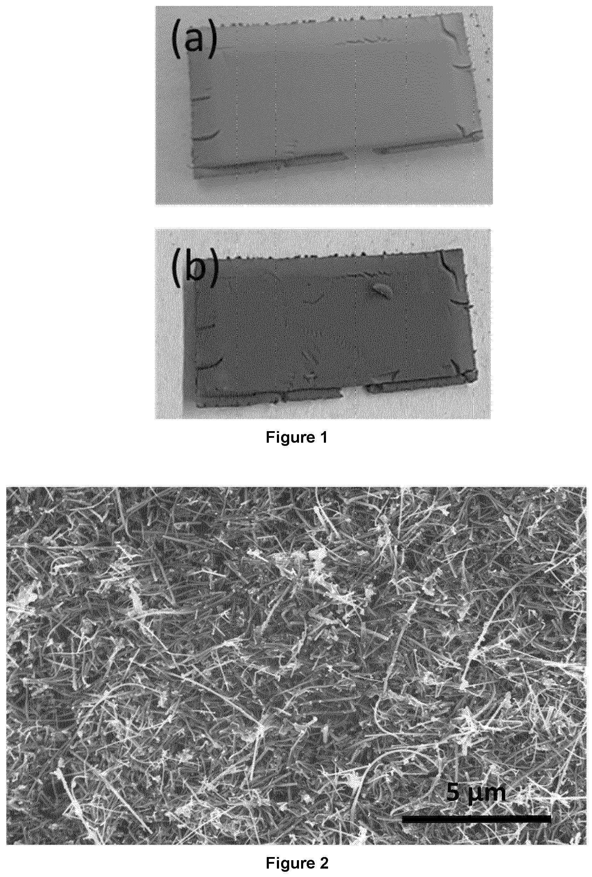

Figure 1 shows an imagen of a self-standing Si nanowire network (a) before and (b) after carbon coating.

Mechanical test results (not displayed herein) showed that the network structure of the electrodes makes them flexible in bending and gives them mechanical properties similar to other fibrillary solids such as paper, with a strain-to-break of above 10% and average specific strength of 1.2 MPa/SG. Thanks to its mechanical robustness, the Si nanowire network coated with a carbon coating was directly combined with a copper current collector without the need of polymer binders or other form of mechanical reinforcement as in other granular electrodes.

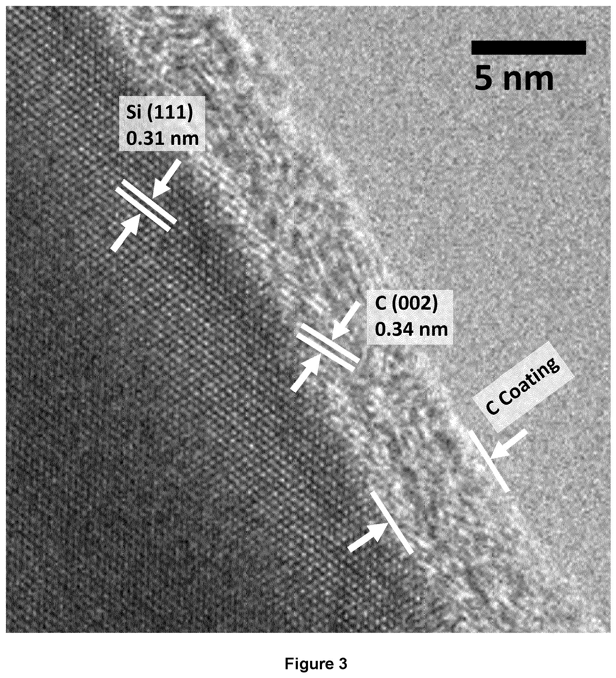

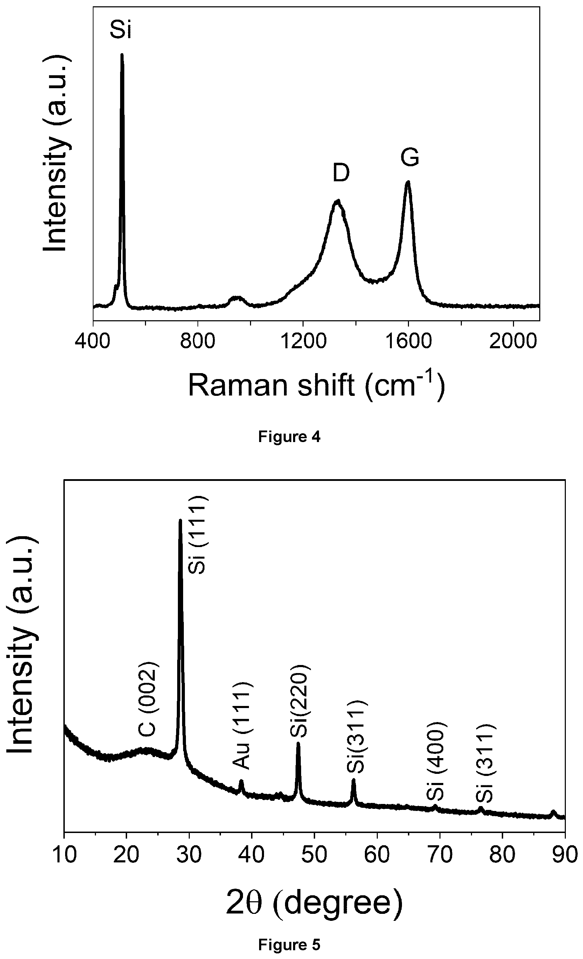

Figure 2 shows electron micrographs of the Si nanowire network before carbon coating. Figure 3 shows a HRTEM micrograph of the interface between the carbon coating and a crystalline Si nanowire of a Si nanowire network after carbon coating. Results of Figure 3 show a preferential alignment of carbon graphitic planes at the interface between the carbon coating and Si nanowire. In addition, Figure 4 shows a representative Raman spectrum showing the crystallinity of the Si nanowires and the graphitization of the coating on the carbon coated Si nanowire network. Figure 5 shows XRD patterns showing no presence of crystalline SiO₂ on the nanowires.

The average length of the nanowires of the network of nanowires obtained was at least 2 microns. Nanowires average diameter and aspect ratio were obtained from a significant number of measurements performed by image analysis of scanning electron micrographs at high magnification. Nanowire lengths were calculated from the product of diameter and aspect ratio. In addition, the nanowires of the nanowire network are crystalline. The samples comprise more than 66.5% crystalline Si nanowires by weight, relative to total weight of the nanowire network coated with carbon (i.e. the electrode excluding the current collector).

The results of the analysis of the samples by electron microscopy showed a C coating with an average thickness of 3.8 ± 1.3 nm, which is uniform throughout the electrode. The carbon coating of the Si network was a combination of graphitic and amorphous domains. Small stacks of graphitic planes are directly observable by high resolution transmission electron microscopy (Figure 3). The high fraction of sp² hybridization on the carbon coating was also confirmed by the relatively narrow G band in the Raman spectrum (Figure 4). In addition, no passivating SiO₂ layer was found on the silicon nanowires after the carbonization process either through electron microscopy or in XRD diffraction patterns. Instead, the interface between the silicon nanowires of the network and the carbon coating comprises crystalline silicon and crystalline graphitic domains which are predominantly aligned. In addition, it was observed that the graphitic (002) basal planes of the coating are oriented parallel to Si (111) plane of the nanowires, and thus slanted relative to the silicon nanowires longitudinal axis, as shown in the example in Figure 3. In the author views the carbon pyrolysis step of the electrode synthesis method is the cause of the chemical reduction of the surface of the silicon nanowires and of the deposition of graphitic carbon planes assisted by nucleation on the crystalline silicon nanowires.

From gravimetric measurements, the mass fraction of the carbon coating is on average about 27 wt% of the total mass of the silicon nanowires network and the carbon coating. The electrode volumetric density is 0.51 g/cm³ equivalent to a porosity of 78%. For the different samples of Si nanowire networks coated with carbon, the electrical conductivity in the plane (σ_{IP}) and out of plane (σ_{OOP}) is in the range of 1-1.5 S/m and 0.1 to 0.6 S/m, respectively. Two-probe electrical resistance measurements were performed on the electrode samples using flat copper tape contacts. The high electrical conductivity values obtained are a consequence of the high uniformity and high graphitisation of the carbon coating.

Accordingly, results showed that the performed pyrolytic reaction has effectively coated the Si nanowire network with a thin (e.g. low mass fraction), uniform carbon layer, capable of providing high electrical conductivity values.

On the contrary, the electrical conductivity values of an electrode comprising just a network of nanowires and an electrical connection or a current collector (without a carbon coating) are much lower.

By comparing with other carbon materials such as carbon black, graphene or carbon nanotubes, the authors observe that, in order to reach similar conductivity values that the coated electrodes of the invention, larger amounts of those materials in a denser sample would be needed.

### Sample characterization

The samples were characterized using Field Effect Scanning Electron Microscopy (FESEM, FEI Helios NanoLab 600i simultaneously acquiring images using TLD and CBS detectors), Transmission Electron Microscopy (TEM, Talos F200X FEG, 200 kV), Raman spectroscopy (Ranishaw, using a 532 nm laser source), and 2D Wide Angle X-ray Scattering (WAXS) and Small-angle X-ray scattering (SAXS). WAXS/SAXS data were collected using a microfocus spot of ~ 10-µm in diameter and a radiation wavelength of λ = 1.0 Å. The collected patterns shown are corrected for background scattering and obtained after azimuthal integration.

### Electrochemical performance

The performance of the electrodes described above was studied in a two-electrode cell as well as in a three-electrode cell configuration using biologic electrochemical workstation (VMP300) and a Neware battery tester (CT-4008-5V10mA-164).

Coin cells (CR 2032) were assembled with the Si network of nanowires coated with carbon described above as the working electrode, a circular lithium foil as the counter, a Whatman GF/D disc along with a PP membrane (25 um), facing the working electrode as separators, and 1 M LiPF6 and 10 wt% fluoroethylene carbonate (FEC) in ethylene carbonate/diethyl carbonate (1:1 v/v, Solvionic) as electrolyte.

The cells were characterized by galvanostatic cycling at the C-rates of C/20 to 2C, cyclic voltammetry at scan rates of 0.1- 10 mV/s in a voltage window of 1.5-0.01 V vs. Li/Li⁺. For the galvanostatic measurements, 1C was considered to 3579 mAh/g corresponding to the formation of Li₁₅Si₄ phase. The cells were also characterized using electrochemical impedance spectroscopy at a frequency window of 10 mHz⁻² MHz with AC amplitude of 10 mV. The specific capacity values are normalized by the mass of silicon.

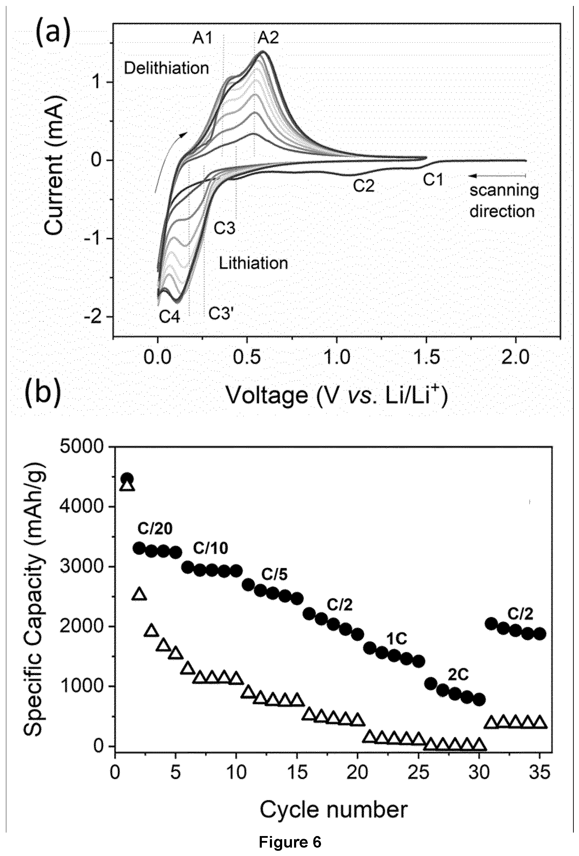

Figure 6 shows (a) the first 10 cyclic voltammograms at a scan rate of 0.025 mV/s and (b) rate performance (specific capacity versus number of cycles) at C rates from C/20 to 2C obtained using the Si nanowire network coated with carbon as electrode in a half-cell. Electrode mass loading: 1.2 mg/cm².

In particular, Figure 6b shows the comparison of the rate performance of a Si nanowire network coated with carbon as electrode in a half-cell at C rates ranging from C/20(≈ 0.179 mA/g) to 2C (≈7.2 mA/g) for two different C contents (i.e. 5 (triangles) and 27% (circles) weight percentage of carbon over the total weight of the nanowires network and the carbon coating).

Results showed (see Figure 6 (b)) that for both Si nanowire network electrodes with different amount of C coatings the first discharge (lithiation) capacity, including the solid electrolyte interphase (SEI) formation, was over 4200 mAh/g (close to the theoretical capacity for silicon upon Li_{4.4}Si formation). As seen on figure 6, after SEI formation, the reversible capacity of the optimized electrode (with 27 wt% carbon coating) was obtained as high as 3310 mAh/g at C/20 (1C is 3.6 A/g) and is maintained steady while the capacity of the electrode with 5 wt% of carbon coating reduced to 2500 mAh/g in the second cycle, falling to 1280 mAh/g after 5 cycles. The specific capacity of the optimized electrode with 27 wt% carbon coating was significantly higher in all the c-rates..

The initial coulombic efficiency (ICE, for instance the ratio of the charge capacity to the discharge capacity in the first cycle) of the Si nanowire network coated with 27 wt% of carbon and acting as electrode was estimated to be ~72%, whereas for the Si nanowire network with only 5 wt% of C coating it is about ~55%.

The Si nanowire network anodes with coated with 27 wt% of a carbon coating of the invention tested in half cells, demonstrated to have near-theoretical capacity at low rates (3041 mAh/g), even at high areal density of 3.1 mg/cm² (9.3 mAh/cm²).

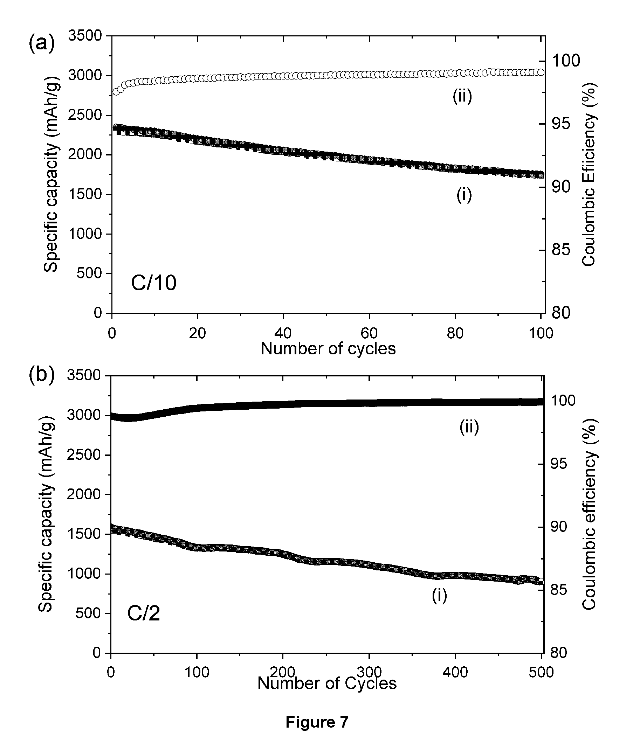

The electrochemical stability of the electrodes was tested. Figure 7 shows specific capacity (i) as well as the coulombic efficiencies (ii) of a Si nanowire network coated with a carbon coating as electrode at C-rates vs number of cycles of (a) C/10 for 100 cycles and (b) C/2 for 500 cycles. Results showed that at C/10 rate, after 100 charge-discharge cycles, the material retains 75% of its initial capacity, whereas the coulombic efficiency improves from 97.6% to 99.1%. At a faster charge-discharge rate of C/2, it retains about 60% of the initial capacity, and the coulombic efficiency increases from 98.8 to 99.9%. Accordingly, it is concluded that the optimized electrodes of the present invention show a high stability with high initial specific capacity.

### Example 2: Comparative example

In a comparative example an electrode was fabricated consisting of the network of nanowires comprising silicon (Si) nanowires synthesized as described in example 1 but without the carbon coating, and interspersed carbon nanotubes. The carbon nanotubes act as electrical conducting additive.

For this example, the electrode was prepared by drop casting an aqueous dispersion of carbon nanotubes onto the Si nanowire network. The aqueous dispersion consisted of a standard, commercial mixture of single-walled carbon nanotubes in water. After casting the carbon nanotube dispersion, the electrode was dried overnight at 120°C in an electric vacuum oven, and immediately transferred to a glovebox for assembly of a coin cell similar to the ones described on Example 1. The mass fraction of the SWCNT in the electrodes was estimated based on the volume drop casted, resulting in a value of 2.5 wt.% of the total weight of the electrode.

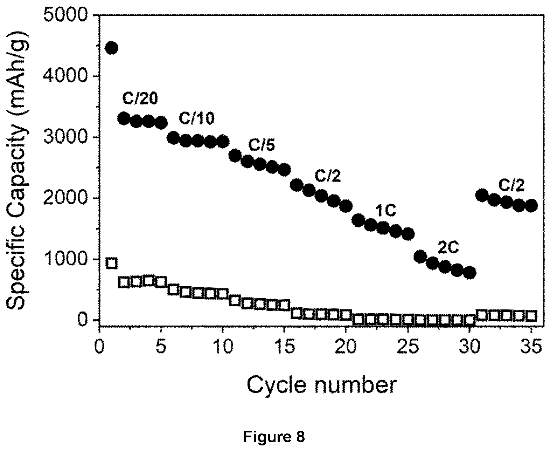

Figure 8 shows the comparison of the rate performance of a Si nanowire network coated with a carbon coating (circles) and a Si nanowire network with interspersed carbon nanotubes (squares) as electrodes in a half-cell at C rates ranging from C/20(≈ 0.179 mA/g) to 2C (≈7.2 mA/g).

The results in Figure 8 showed that the specific capacity at all rates is much lower for the Si nanowire network with interspersed carbon nanotubes, compared to the Si nanowire network anodes with a carbon coating.

## Claims

1. A method for preparing an electrode comprising:
(a) preparing a network of nanowires by a method comprising the steps of:
i. providing a first gas flow to a reaction vessel;
wherein said first gas flow comprises at least one precursor compound comprising at least one element selected from Si, Ge, Al, Cu, Zn, Sb, Ni, Ti, Se, Ta, Pt, Mo, V, W, Co, Mn and Li; wherein the at least one precursor compound is a metallic hydride or an organometallic compound; and
ii. providing a second gas flow to the reaction vessel, said second gas flow comprising metallic catalyst particles; as the first and second gas flows are mixed in the reaction vessel to form a gas flow mixture; wherein the metallic catalyst particles comprise one or more element selected from Au, Ag, Cu, Fe, Ni, Ga, Co, Pt, In and Al;
wherein the at least one precursor compound is in the gas flow mixture in a mole fraction (xi) of at least 0.010;
wherein the temperature inside the reaction vessel ranges from 200 to 3000 °C; and
wherein the at least one precursor compound decomposes under the temperature inside the reaction vessel and grows on the metallic catalyst particles by vapor liquid-solid (VLS) and/or chemical vapor deposition (CVD) to form a network of nanowires; and
(b) coating the network of nanowires resulting from step (a) by pyrolysis of a carbon precursor at a temperature of between 500 and 1300°C under an inert gas atmosphere to obtain a network of nanowires coated with a carbon coating; and
optionally, contacting the network of nanowires coated with a carbon coating with an electrical connection or current collector.

2. The method according to claim 1, wherein the at least one precursor compound of step (a) comprises one element selected from Si and Ge.

3. The method according to any of the previous claims, wherein the at least one precursor compound of step (a) is selected from the group consisting of (3-Aminopropyl)triethoxysilane, N-sec-Butyl(trimethylsilyl)amine, chloropentamethyldisilane, tetramethylsilane, silicon tetrabromide, silicon tetrachloride, tris(tert-butoxy)silanol, SiH₄, tetramethylgermanium, triethylgermanium hydride, triphenylgermanium hydride, and tributylgermanium hydride.

4. The method according to any of the previous claims, wherein the metallic catalyst particles of step (a) are gold particles; preferably having diameters of between 0.1 and 100 nm, wherein the diameters are measured according to the method specified in the description.

5. The method according to any of the previous claims,
- wherein the gas flow mixture of step (a) comprises H₂; and/or
- wherein the inert atmosphere of step (b) comprises argon or nitrogen gas; and/or
- wherein the carbon precursor of step (b) is an organic molecule; preferably a hydrocarbon; and/or
- wherein step (b) is performed in the same reaction vessel than step (a); and/or wherein the carbon precursor is part of an additional gas flow introduced into the reaction vessel of step (a).

6. An electrode obtainable by the method according to any of the previous claims, comprising:
- a network of nanowires coated with a carbon coating;
wherein the aspect ratio of the nanowires of the network of nanowires is at least 130, wherein the aspect ratio is measured according to the method specified in the description;
wherein the carbon coating comprises graphitic carbon; and wherein the carbon coating is in an amount of more than a 3 wt.% of the total weight of the network of nanowires coated with the carbon coating;
wherein the network of nanowires is a continuous network;
- optionally, an electrical connection and/or a current collector.

7. The electrode according to claim 6; wherein the nanowires composition is selected from Si, SiC, Ge, SiₓGe₁₋ₓ, SiOₓ, AlₓGa₁₋ₓAs_{y}P_{1-y}, Al_{z}GaₓIn_{1-x-z}N, AIN, Cu, CuOₓ, ZnOₓ, GaSb, GaₓIn₁₋ₓAs_{y}Sb_{1-y}, NiTe_{y}, LiₓNi_{y}Mn_{z}O, Niₓ, TiOₓ, NbSe_{y}, Taₓ, TaSe_{y}, Pt, MoTe_{y}, MoS_{y}, VOₓ, WS_{y}, CoOₓ, MnOₓ, LiₓMn_{y}O, and LiₓNi_{y}Mn_{z}O; wherein 0≤x≥1, 0≤y≥1 and 0≤z≥1; preferably wherein the nanowires consists of Si, SiC, Ge or SiₓGe₁₋ₓ and SiOₓ where 0≤x≥1.

8. The electrode according to any of claims 6 or 7,
wherein the nanowires of the network of nanowires are crystalline; and
wherein the carbon coating is in an amount of at least 5 wt% of the total weight of the of the network of nanowires coated with the carbon coating.

9. The electrode according to claim 8, wherein the graphitic carbon of the carbon coating comprises carbon graphitic planes aligned with the crystalline planes of the nanowires at the interface between the carbon coating and the nanowires.

10. The electrode according to any of claims 6 to 9, wherein the carbon coating has a thickness of between 1 and 10 nm; and/or
wherein the carbon coating has a volumetric density of between 0.05 and 0.70 g/cm³; wherein the volumetric density has been measured by determining the mass gravimetrically and dividing it by the volume of the electrode.

11. The electrode according to any of claims 6 to 10, consisting of a network of nanowires coated with a carbon coating and optionally, an electrical connection or current collector; and/or
wherein the carbon coating consists of graphitic carbon and amorphous carbon.

12. A cell comprising:
- electrodes, wherein at least one electrode is as described in any of claims 6-11;
- an electrolyte; and
- means for connecting with a power/load source.

13. The cell according to claim 12, wherein the electrode as described in any of claims 6-11 is a working electrode.

14. The cell according to any of claims 12 or 13, wherein the electrolyte comprises lithium.

15. Use of the electrode according to any of claims 6-11, in batteries; preferably in lithium batteries.

## Patentansprüche

1. Ein Verfahren zur Herstellung einer Elektrode, umfassend:
(a) das Herstellen eines Netzwerks aus Nanodrähten durch ein Verfahren, das die Schritte umfasst:
i. das Zuführen eines ersten Gasstroms zu einem Reaktionsgefäß; wobei der erste Gasstrom mindestens eine Vorläuferverbindung umfasst, die mindestens ein Element umfasst, das aus Si, Ge, Al, Cu, Zn, Sb, Ni, Ti, Se, Ta, Pt, Mo, V, W, Co, Mn und Li ausgewählt ist; wobei die mindestens eine Vorläuferverbindung ein Metallhydrid oder eine metallorganische Verbindung ist; und
ii. das Zuführen eines zweiten Gasstroms zu dem Reaktionsgefäß, wobei der zweite Gasstrom metallische Katalysatorpartikel umfasst; wobei der erste und der zweite Gasstrom im Reaktionsgefäß gemischt werden, um eine Gasstrommischung zu bilden; wobei die metallischen Katalysatorpartikel ein oder mehrere Elemente umfassen, die aus Au, Ag, Cu, Fe, Ni, Ga, Co, Pt, In und Al ausgewählt sind;
wobei die mindestens eine Vorläuferverbindung in der Gasstrommischung in einem Molanteil (xi) von mindestens 0,010 vorliegt;
wobei die Temperatur innerhalb des Reaktionsgefäßes im Bereich von 200 bis 3000 °C liegt; und
wobei sich die mindestens eine Vorläuferverbindung bei der Temperatur innerhalb des Reaktionsgefäßes zersetzt und durch Dampf-Flüssig-Fest-Abscheidung (VLS) und/oder chemische Gasphasenabscheidung (CVD) auf den metallischen Katalysatorpartikeln wächst, um ein Netzwerk aus Nanodrähten zu bilden; und
(b) das Beschichten des aus Schritt (a) resultierenden Netzwerks aus Nanodrähten durch Pyrolyse eines Kohlenstoffvorläufers bei einer Temperatur zwischen 500 und 1300 °C unter einer Inertgasatmosphäre, um ein mit einer Kohlenstoffbeschichtung beschichtetes Netzwerk aus Nanodrähten zu erhalten; und gegebenenfalls das Inkontaktbringen des mit einer Kohlenstoffbeschichtung beschichteten Netzwerks aus Nanodrähten mit einer elektrischen Verbindung oder einem Stromkollektor.

2. Das Verfahren nach Anspruch 1, wobei die mindestens eine Vorläuferverbindung aus Schritt (a) ein Element umfasst, das aus Si und Ge ausgewählt ist.

3. Das Verfahren nach einem der vorstehenden Ansprüche, wobei die mindestens eine Vorläuferverbindung aus Schritt (a) aus der Gruppe ausgewählt ist, bestehend aus (3-Aminopropyl)triethoxysilan, N-sec-Butyl(trimethylsilyl)amin, Chlorpentamethyldisilan, Tetramethylsilan, Siliciumtetrabromid, Siliciumtetrachlorid, Tris(tert-butoxy)silanol, SiH₄, Tetramethylgermanium, Triethylgermaniumhydrid, Triphenylgermaniumhydrid und Tributylgermaniumhydrid.

4. Das Verfahren nach einem der vorstehenden Ansprüche, wobei die metallischen Katalysatorpartikel aus Schritt (a) Goldpartikel sind; vorzugsweise mit Durchmessern zwischen 0,1 und 100 nm, wobei die Durchmesser gemäß dem in der Beschreibung angegebenen Verfahren gemessen werden.

5. Das Verfahren nach einem der vorstehenden Ansprüche,
- wobei die Gasstrommischung aus Schritt (a) H₂ umfasst; und/oder
- wobei die Inertatmosphäre aus Schritt (b) Argon oder Stickstoffgas umfasst; und/oder
- wobei der Kohlenstoffvorläufer aus Schritt (b) ein organisches Molekül ist; vorzugsweise ein Kohlenwasserstoff; und/oder
- wobei Schritt (b) in demselben Reaktionsgefäß wie Schritt (a) durchgeführt wird; und/oder wobei der Kohlenstoffvorläufer Teil eines zusätzlichen Gasstroms ist, der in das Reaktionsgefäß von Schritt (a) eingeleitet wird.

6. Eine Elektrode, die nach dem Verfahren nach einem der vorstehenden Ansprüche herstellbar ist, umfassend:
- ein Netzwerk aus Nanodrähten, die mit einer Kohlenstoffbeschichtung beschichtet sind;
wobei das Seitenverhältnis der Nanodrähte des Netzwerks aus Nanodrähten mindestens 130 beträgt, wobei das Seitenverhältnis gemäß dem in der Beschreibung angegebenen Verfahren gemessen wird;
wobei die Kohlenstoffbeschichtung graphitischen Kohlenstoff umfasst; und
wobei die Kohlenstoffbeschichtung in einer Menge von mehr als 3 Gew.-% des Gesamtgewichts des mit der Kohlenstoffbeschichtung beschichteten Netzwerks aus Nanodrähten vorliegt;
wobei das Netzwerk aus Nanodrähten ein kontinuierliches Netzwerk ist;
- gegebenenfalls eine elektrische Verbindung und/oder einen Stromkollektor.

7. Die Elektrode nach Anspruch 6; wobei die Nanodrahtzusammensetzung ausgewählt ist aus Si, SiC, Ge, SiₓGe₁₋ₓ, SiOₓ, AlₓGa₁₋ₓAs_{y}P_{1-y}, Al_{z}GaₓIn_{1-x-z}N, AlN, Cu, CuOₓ, ZnOₓ, GaSb, GaₓIn₁₋ₓAs_{y}Sb_{1-y}, NiTe_{y}, LiₓNi_{y}Mn_{z}O, Niₓ, TiOₓ, NbSe_{y}, Taₓ, TaSe_{y}, Pt, MoTe_{y}, MoS_{y}, VOₓ, WS_{y}, CoOₓ, MnOₓ, LiₓMn_{y}O und LiₓNi_{y}Mn_{z}O; wobei 0≤x≥1, 0≤y≥1 und 0≤z≥1; wobei vorzugsweise die Nanodrähte aus Si, SiC, Ge oder SiₓGe₁₋ₓ und SiOₓ bestehen, wobei 0≤x≥1.

8. Die Elektrode nach einem der Ansprüche 6 oder 7,
wobei die Nanodrähte des Netzwerks aus Nanodrähten kristallin sind; und
wobei die Kohlenstoffbeschichtung eine Menge von mindestens 5 Gew.-% des Gesamtgewichts des mit der Kohlenstoffbeschichtung beschichteten Netzwerks aus Nanodrähten ausmacht.

9. Die Elektrode nach Anspruch 8, wobei der graphitische Kohlenstoff der Kohlenstoffbeschichtung graphitische Kohlenstoffebenen umfasst, die an der Grenzfläche zwischen der Kohlenstoffbeschichtung und den Nanodrähten auf die Kristallebenen der Nanodrähte ausgerichtet sind.

10. Die Elektrode nach einem der Ansprüche 6 bis 9, wobei die Kohlenstoffbeschichtung eine Dicke zwischen 1 und 10 nm aufweist; und/oder
wobei die Kohlenstoffbeschichtung eine Volumendichte zwischen 0,05 und 0,70 g/cm³ aufweist; wobei die Volumendichte durch gravimetrische Bestimmung der Masse und Division dieser durch das Volumen der Elektrode gemessen wurde.

11. Die Elektrode nach einem der Ansprüche 6 bis 10, bestehend aus einem Netzwerk aus Nanodrähten, die mit einer Kohlenstoffbeschichtung beschichtet sind, und gegebenenfalls einer elektrischen Verbindung oder einem Stromkollektor; und/oder
wobei die Kohlenstoffbeschichtung aus graphitischem Kohlenstoff und amorphem Kohlenstoff besteht.

12. Eine Zelle, umfassend:
- Elektroden, wobei mindestens eine Elektrode wie in einem der Ansprüche 6-11 beschrieben ist;
- einen Elektrolyten; und
- Mittel zum Anschluss an eine Strom-/Lastquelle.

13. Die Zelle nach Anspruch 12, wobei die in einem der Ansprüche 6-11 beschriebene Elektrode eine Arbeitselektrode ist.

14. Die Zelle nach einem der Ansprüche 12 oder 13, wobei der Elektrolyt Lithium umfasst.

15. Verwendung der Elektrode nach einem der Ansprüche 6-11 in Batterien; vorzugsweise in Lithiumbatterien.

## Revendications

1. Un procédé de préparation d'une électrode comprenant :
(a) la préparation d'un réseau de nanofils par un procédé comprenant les étapes suivantes :
i. la fourniture d'un premier flux gazeux dans un récipient de réaction ; dans lequel ledit premier flux gazeux comprend au moins un composé précurseur comprenant au moins un élément choisi parmi Si, Ge, Al, Cu, Zn, Sb, Ni, Ti, Se, Ta, Pt, Mo, V, W, Co, Mn et Li ; dans lequel le au moins un composé précurseur est un hydrure métallique ou un composé organométallique ; et
ii. la fourniture d'un second flux gazeux dans le récipient de réaction, ledit second flux gazeux comprenant des particules de catalyseur métallique ; le premier et le second flux gazeux étant mélangés dans le récipient de réaction pour former un mélange de flux gazeux ; dans lequel les particules de catalyseur métallique comprennent un ou plusieurs éléments choisis parmi Au, Ag, Cu, Fe, Ni, Ga, Co, Pt, In et Al ;
dans lequel le au moins un composé précurseur est présent dans le mélange de flux gazeux à une fraction molaire (xi) d'au moins 0,010 ; dans lequel la température à l'intérieur du récipient de réaction est comprise entre 200 et 3000 °C ; et
dans lequel le au moins un composé précurseur se décompose sous la température à l'intérieur du récipient de réaction et croît sur les particules de catalyseur métallique par dépôt vapeur-liquide-solide (VLS) et/ou dépôt chimique en phase vapeur (CVD) pour former un réseau de nanofils ; et
(b) le revêtement du réseau de nanofils résultant de l'étape (a) par pyrolyse d'un précurseur carboné à une température comprise entre 500 et 1300 °C sous une atmosphère de gaz inerte pour obtenir un réseau de nanofils revêtu d'un revêtement de carbone ; et
optionnellement, la mise en contact du réseau de nanofils revêtu d'un revêtement de carbone avec une connexion électrique ou un collecteur de courant.

2. Le procédé selon la revendication 1, dans lequel le au moins un composé précurseur de l'étape (a) comprend un élément choisi parmi Si et Ge.

3. Le procédé selon l'une quelconque des revendications précédentes, dans lequel le au moins un composé précurseur de l'étape (a) est choisi dans le groupe constitué par le (3-aminopropyl)triéthoxysilane, la N-sec-butyl(triméthylsilyl)amine, le chloropentaméthyldisilane, le tétraméthylsilane, le tétrabromure de silicium, le tétrachlorure de silicium, le tris(tert-butoxy)silanol, SiH₄, le tétraméthylgermanium, l'hydrure de triéthylgermanium, l'hydrure de triphénylgermanium et l'hydrure de tributylgermanium.

4. Le procédé selon l'une quelconque des revendications précédentes, dans lequel les particules de catalyseur métallique de l'étape (a) sont des particules d'or ; ayant de préférence des diamètres compris entre 0,1 et 100 nm, dans lequel les diamètres sont mesurés selon la méthode spécifiée dans la description.

5. Le procédé selon l'une quelconque des revendications précédentes,
- dans lequel le mélange de flux gazeux de l'étape (a) comprend H₂ ; et/ou
- dans lequel l'atmosphère inerte de l'étape (b) comprend de l'argon ou de l'azote gazeux ; et/ou
- dans lequel le précurseur carboné de l'étape (b) est une molécule organique ; de préférence un hydrocarbure ; et/ou
- dans lequel l'étape (b) est réalisée dans le même récipient de réaction que l'étape (a) ; et/ou dans lequel le précurseur carboné fait partie d'un flux gazeux supplémentaire introduit dans le récipient de réaction de l'étape (a).

6. Une électrode pouvant être obtenue par le procédé selon l'une quelconque des revendications précédentes, comprenant :
- un réseau de nanofils revêtu d'un revêtement de carbone ;
dans lequel le rapport d'aspect des nanofils du réseau de nanofils est d'au moins 130, dans lequel le rapport d'aspect est mesuré conformément à la méthode spécifiée dans la description ;
dans lequel le revêtement de carbone comprend du carbone graphitique ; et
dans lequel le revêtement de carbone est présent en une quantité de plus de 3 % en poids du poids total du réseau de nanofils revêtu du revêtement de carbone ; dans lequel le réseau de nanofils est un réseau continu ;
- optionnellement, une connexion électrique et/ou un collecteur de courant.

7. L'électrode selon la revendication 6 ; dans laquelle la composition des nanofils est choisie parmi Si, SiC, Ge, SiₓGe₁₋ₓ, SiOₓ, AlₓGa₁₋ₓAs_{y}P_{1-y}, Al_{z}Ga_{X}In_{1-x-z}N, AlN, Cu, CuOₓ, ZnOₓ, GaSb, GaₓIn₁₋ₓAs_{y}Sb_{1-y}, NiTe_{y}, LiₓNi_{y}Mn_{z}O, Niₓ, TiOₓ, NbSe_{y}, Taₓ, TaSe_{y}, Pt, MoTe_{y}, MoS_{y}, VOₓ, WS_{y}, CoOₓ, MnOₓ, LiₓMn_{y}O, et LiₓNi_{y}Mn_{z}O ; dans laquelle 0≤x≥1, 0≤y≥1 et 0≤z≥1 ; de préférence dans laquelle les nanofils sont constitués de Si, SiC, Ge ou SiₓGe₁₋ₓ, et SiOₓ où 0≤x≥1.

8. L'électrode selon l'une quelconque des revendications 6 ou 7,
dans laquelle les nanofils du réseau de nanofils sont cristallins ; et
dans laquelle le revêtement de carbone est présent en une quantité d'au moins 5 % en poids du poids total du réseau de nanofils revêtu du revêtement de carbone.

9. L'électrode selon la revendication 8, dans laquelle le carbone graphitique du revêtement de carbone comprend des plans graphitiques de carbone alignés avec les plans cristallins des nanofils à l'interface entre le revêtement de carbone et les nanofils.

10. L'électrode selon l'une quelconque des revendications 6 à 9, dans laquelle le revêtement de carbone a une épaisseur comprise entre 1 et 10 nm ; et/ou dans laquelle le revêtement de carbone a une masse volumique comprise entre 0,05 et 0,70 g/cm³; dans laquelle la masse volumique a été mesurée en déterminant la masse par gravimétrie et en la divisant par le volume de l'électrode.

11. L'électrode selon l'une quelconque des revendications 6 à 10, constituée d'un réseau de nanofils revêtu d'un revêtement de carbone et optionnellement, d'une connexion électrique ou d'un collecteur de courant ; et/ou
dans laquelle le revêtement de carbone est constitué de carbone graphitique et de carbone amorphe.

12. Une cellule comprenant :
- des électrodes, dans laquelle au moins une électrode est telle que décrite dans l'une quelconque des revendications 6-11 ;
- un électrolyte ; et
- des moyens de connexion avec une source de puissance/charge.

13. La cellule selon la revendication 12, dans laquelle l'électrode telle que décrite dans l'une quelconque des revendications 6-11 est une électrode de travail.

14. La cellule selon l'une quelconque des revendications 12 ou 13, dans laquelle l'électrolyte comprend du lithium.

15. Utilisation de l'électrode selon l'une quelconque des revendications 6-11, dans des batteries ; de préférence dans des batteries au lithium.
